# EUROPEAN PATENT APPLICATION

(11) **EP 2 693 471 A2**
(43) Date of publication of application: **05.02.2014**
(21) Application number: 12184224.9
(22) Date of filing: 13.09.2012
(51) Int. Cl.: H01L 23/367, F21V 29/00, F21Y 101/02

(54) **Semiconductor device and method for manufacturing the same**

(30) Priority: 31.07.2012 JP 2012170617
(71) Applicant: Toshiba Lighting & Technology Corporation, Yokosuka-shi Kanagawa 237-8510 (JP)
(72) Inventor: Shimokawa, Kazuo, Kanagawa 237-8510 (JP)
(74) Representative: Willquist, Sofia Ellinor

(57) **Abstract**

A semiconductor device (1, 2, 3) according to an embodiment includes a heat dissipation member (11) having a first upper surface (11a), the first upper surface (11a) being provided with grooves (17) formed on the first upper surface (11a) ; a bonding member (12) provided on the heat dissipation member (11) and burying the grooves (17); and a wiring substrate (14) provided on the bonding member (12), the wiring substrate (12) having a second upper surface (14u) and a lower surface (141) opposite to the second upper surface (14u), the wiring substrate (14) including a semiconductor unit (15) and a bonding electrode (13), the semiconductor unit (15) being provided on the second upper surface (14u) and including a light emitting layer (15E), the bonding electrode (13) being provided on the lower surface (141), the bonding electrode (13) being bonded to the heat dissipation member (11) via the bonding member (12).

## Description

### FIELD

Embodiments described herein relate generally to a semiconductor device and a method for manufacturing the same.

### BACKGROUND

There is a semiconductor device in which a plurality of semiconductor elements (for example, semiconductor light emitting elements) are very densely mounted. For example, in a semiconductor light emitting element, there are cases where 70% of flowing current is changed to heat. For this reason, it is necessary to secure a heat dissipation path for efficient heat dissipation.

### DESCRIPTION OF THE DRAWINGS

FIGS. 1A to 1D are schematic diagrams illustrating a configuration of a semiconductor device according to a first embodiment,
FIGS. 2A and 2B are schematic diagrams illustrating a configuration of the semiconductor device,
FIGS. 3A to 3E are schematic diagrams illustrating a manufacturing method of the semiconductor device,
FIGS. 4A and 4B are cross-sectional views illustrating a manufacturing method of the semiconductor device,
FIG. 5 is a flowchart illustrating a manufacturing method of the semiconductor device,
FIG. 6 is a graph illustrating a manufacturing method of the semiconductor device,
FIGS. 7A to 7D are schematic cross-sectional views illustrating a manufacturing method of the semiconductor device,
FIGS. 8A to 8D are schematic cross-sectional views illustrating a manufacturing method of the semiconductor device,
FIGS. 9A to 9C are schematic cross-sectional views illustrating a manufacturing method of the semiconductor device,
FIGS. 10A and 10B are schematic cross-sectional views illustrating a manufacturing method of a semiconductor device according to a reference example,
FIGS. 11A and 11B are schematic cross-sectional views illustrating a manufacturing method of the semiconductor device,
FIGS. 12A to 12C are schematic cross-sectional views illustrating a manufacturing method of the semiconductor device,
FIG. 13 is a schematic cross-sectional view illustrating a configuration of another semiconductor device according to the first embodiment,
FIGS. 14A to 14D are schematic diagrams illustrating a configuration of a semiconductor device according to a second embodiment,
FIGS. 15A to 15D are schematic diagrams illustrating a manufacturing method of the semiconductor device,
FIG. 16 is a schematic cross-sectional view illustrating a configuration of another semiconductor device according to the second embodiment,
FIGS. 17A to 17C are schematic diagrams illustrating a configuration of a semiconductor device according to a third embodiment, and
FIGS. 18A to 18C are schematic diagrams illustrating a configuration of another semiconductor device according to the third embodiment.

### DETAILED DESCRIPTION

A semiconductor device according to an embodiment includes a heat dissipation member having a first upper surface, the first upper surface being provided with grooves formed on the first upper surface; a bonding member provided on the heat dissipation member and burying the grooves; and a wiring substrate provided on the bonding member, the wiring substrate having a second upper surface and a lower surface opposite to the second upper surface, the wiring substrate including a semiconductor unit and a bonding electrode, the semiconductor unit being provided on the second upper surface and including a light emitting layer, the bonding electrode being provided on the lower surface, the bonding electrode being bonded to the heat dissipation member via the bonding member.

A method for manufacturing a semiconductor device according to an embodiment includes providing a bonding member on a heat dissipation member, the heat dissipation member having a first upper surface, the upper surface being provided with grooves formed on the upper surface; placing a wiring substrate on the bonding member, the wiring substrate having a second upper surface and a lower surface opposite to the second upper surface, the wiring substrate including a semiconductor unit and a bonding electrode, the semiconductor unit being provided on the second upper surface and including a light emitting layer, the bonding electrode being provided on the lower surface; and bonding the bonding electrode to the heat dissipation member via the bonding member by burying the grooves with the bonding member.

Hereinafter, each embodiment will be described with reference to the drawings.

In addition, the drawings are schematic or conceptual, and a relationship between the thickness and the width of each portion, a ratio of the sizes between portions, and the like are not necessarily the same as practical portions. Further, even if the same portion is shown, the dimension or the ratio may be shown differently depending on the drawings in some cases.

In addition, in the present specification and the drawings, the same constituent elements as those described in the previous drawings are given the same reference numerals, and detailed description thereof will be appropriately omitted.

### First Embodiment

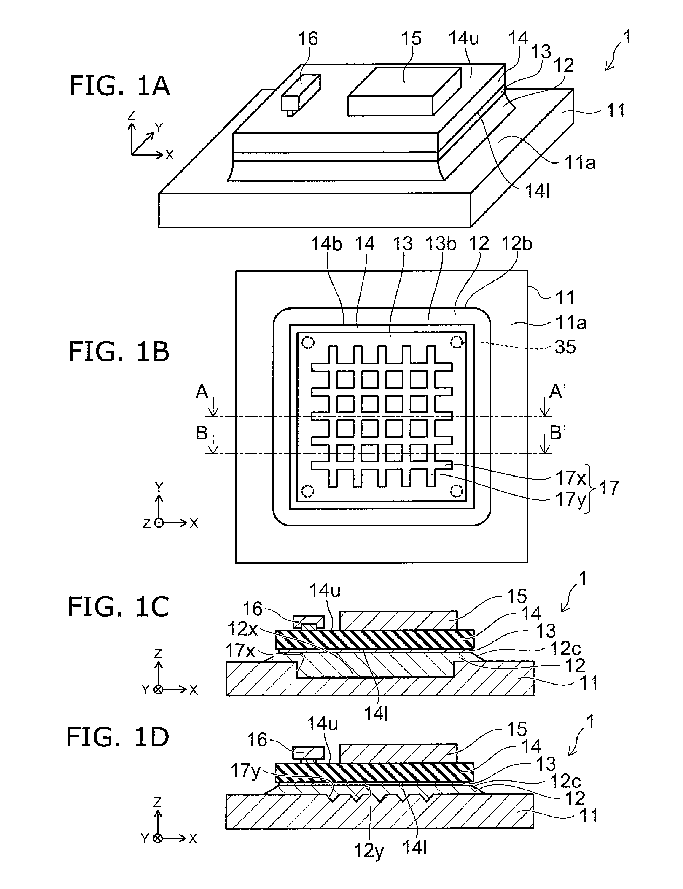

FIGS. 1A to 1D are schematic diagrams illustrating a configuration of the semiconductor device according to a first embodiment.

FIG. 1A is a perspective view. FIG. 1B is a plan view. FIG. 1C is a cross-sectional view taken along the line A-A' of FIG. 1B. FIG. 1D is a cross-sectional view taken along the line B-B' of FIG. 1B.

As shown in FIGS. 1A to 1C, a semiconductor device 1 (for example, a light emitting device) is provided with a heat dissipation member 11, a bonding member 12, a bonding electrode 13, a wiring substrate 14, a light emitting unit 15 (for example, a semiconductor unit), and a connector 16.

Grooves 17 are formed on an upper surface 11a (first upper surface) of the heat dissipation member 11. The bonding member 12 is provided on the heat dissipation member 11. The bonding member 12 buries the grooves 17 therein. The wiring substrate 14 has an upper surface 14u (second upper surface) and a lower surface 141. The wiring substrate 14 includes the light emitting portion 15 provided on the upper surface 14u and the bonding electrode 13 provided on the lower surface 141. The bonding electrode 13 is joined to the heat dissipation member 11 via the bonding member 12.

The heat dissipation member 11 uses a material (for example, metal) with high thermal conductivity. The heat dissipation member 11 includes, for example, copper (Cu). The heat dissipation member 11 includes, for example, at least one metal selected from a group consisting of copper, aluminum (A1), iron (Fe), and molybdenum (Mo). The heat dissipation member 11 may use, for example, a single material or composite materials. A structure where a plurality of layers are laminated such as, for example, a structure where a molybdenum layer is interposed between copper layers, may be applied to the heat dissipation member 11.

A plated layer may be provided on the surface of the heat dissipation member 11. The plated layer may be provided on the entire surface of the heat dissipation member 11 or a part of the surface thereof. If the plated layer is provided on a portion of the surface, for example, the plated layer is provided at a portion which comes into contact with the bonding member 12 on the surface of the heat dissipation member 11. The plated layer may be formed of a single layer or two or more layers.

If the plated layer is formed of a single layer, the plated layer includes at least one metal selected from a group consisting of, for example, nickel (Ni), tin (Sn), palladium (Pd), silver (Ag), and gold (Au). For example, the plated layer preferably suppresses diffusion of metal included in the heat dissipation member 11. Thereby, it is possible to suppress deterioration in a bonding strength due to material diffusion at the bonding portion between the heat dissipation member 11 and the bonding member 12 via the plated layer. Therefore, long-term reliability of the bonding portion is improved.

If the plated layer is formed of two layers, a first layer included in the played layer uses, for example, nickel. A second layer included in the plated layer uses, for example, either a layer including a laminate (Ni/Pd) of nickel and palladium (Pd) , an alloy, or silver, or a layer including gold. In this case, the first layer of the plated layer provided on the heat dissipation member 11 side preferably suppresses diffusion of metal included in the heat dissipation member 11. The second layer preferably has wettability with a solder material.

If the plated layer is formed of three layers, for example, a first layer includes nickel, a second layer includes palladium, and a third layer includes gold. The first layer of the plated layer provided on the heat dissipation member 11 side preferably suppresses diffusion of metal included in the heat dissipation member 11. The intermediate second layer preferably has, for example, light reflection characteristics. The third layer preferably has wettability with a solder material.

A plating method may be electrolytic plating or non-electrolytic plating. A shape of the heat dissipation member 11 is, for example, a plate shape. The upper surface 11a of the heat dissipation member 11 has, for example, a rectangular shape.

One direction parallel to the upper surface 11a of the heat dissipation member 11 is set to an X direction. A direction which is parallel to the upper surface 11a and is perpendicular to the X direction is set to a Y direction. A direction perpendicular to the upper surface 11a is set to a Z direction.

One side surface of the heat dissipation member 11 is parallel to the X direction. Another side surface of the heat dissipation member 11 is parallel to the Y direction. Each of the lengths in the X direction and the Y direction of the heat dissipation member 11 is, for example, 50 mm. The thickness of the heat dissipation member 11 is, for example, 0.5 to 10 mm. In this example, the thickness thereof is, for example, 2 mm. The embodiment is not limited thereto, and the dimension of the heat dissipation member 11 is arbitrary.

As shown in FIGS. 1B to 1D, the grooves 17 are provided on the upper surface 11a of the heat dissipation member 11. The grooves 17 include a plurality of first groove portions 17x and a plurality of second groove portions 17y intersecting the first groove portions 17x. In this example, the first groove portions 17x extend in one direction (X direction). In addition, the second groove portions 17y extend in the other direction (Y direction). In this example, the first groove portions 17x and the second groove portions 17y extend in a straight line shape. However, the embodiment is not limited thereto, and at least some of the groove portions may extend in a curved shape. The groove portions may have a curved part. The first groove portions 17x may be provided, and the second groove portions 17y may be omitted.

A plurality of the first groove portions 17x and a plurality of the second groove portions 17y intersect each other. A shape when the grooves 17 are viewed from the upper side is a lattice shape.

A plurality of the first groove portions 17x are arranged in the Y direction. An interval between a plurality of the first groove portions 17x may be constant but need not to be constant. In this example, the interval is constant. In other words, the first groove portions 17x are periodically provided. The period is, for example, 50 µm or more to 2 mm or less. In this example, the period is 100 µm.

A plurality of the second groove portions 17y are arranged in the X direction. An interval between a plurality of the second groove portions 17y may be constant but need not to be constant. In this example, the interval is constant. The period is, for example, 50 µm or more to 2 mm or less. In this example, the period is 100 µm. The depth of the first groove portions 17x and the second groove portions 17y is, for example, 5 µm or more to 200 µm or less. In this example, the depth is 20 µm.

A cross-sectional shape of the first groove portions 17x perpendicular to the extending direction of the first groove portions 17x is a V shape. A cross-sectional shape of the second groove portions 17y perpendicular to the extending direction of the second groove portions 17y is a V shape. An angle between two inclined surfaces forming the V shape is, for example, 90 degrees. In addition, this angle need not to be 90 degrees. A cross-sectional shape of the first groove portions 17x and the second groove portions 17y is not limited to the V shape. A cross-sectional shape may be a semicircular shape or a quadrangular shape. The grooves 17 may include a plurality of groove portions which extend in three or more directions. The extending directions of the groove portions may be parallel, perpendicular, or inclined to the side surface of the wiring substrate 14 of the heat dissipation member 11.

In the embodiment, the number of groove portions, a shape of groove portions, and a disposition of groove portions are arbitrary.

In this example, a plurality of protrusions 35 are provided on the heat dissipation member 11. The number of the protrusions 35 is, for example, three or more. The protrusions 35 are disposed, for example, in regions directly below corners of the wiring substrate 14 described later. The height of the protrusions 35 is, for example, 50 µm or more to 200 µm or less. In this example, the height is 100 µm. A shape of the protrusions 35 is a columnar shape or a conical shape. The outer diameter of the bottom of the protrusion is, for example, 50 µm or more to 200 µm or less. The protrusions 35 control, for example, the thickness of the bonding member 12 described later.

The protrusions 35 are provided as necessary. For example, if a thickness is controlled by mixing metal particles with a solder material (bonding member 12) described later, the protrusions 35 may be omitted.

The bonding member 12 is disposed on the heat dissipation member 11. The bonding member 12 buries the grooves 17 therein. The bonding member 12 covers regions directly above the grooves 17. Convex portions along the shape of the grooves 17 are formed on the lower surface of the bonding member 12. The convex portions include a plurality of first protruding portions 12x extending in the X direction and a plurality of second protruding portions 12y extending in the Y direction.

A shape of the bonding member 12 when projected onto the X-Y plane (a plane parallel to the upper surface 11a of the heat dissipation member 11) is substantially rectangular. In this example, when projected onto the X-Y plane, the grooves 17 are located inside an outer edge 12b of the bonding member 12. The outer edge 12b is separated from the grooves 17. The outer edge 12b does not intersect the grooves 17. A taper 12c which spreads on the side of the heat dissipation member 11 is formed in the side surface of the bonding member 12, and the side surface of the taper 12c spreads to outside on the lower side. An outer edge of the surface of the bonding member 12 coming into contact with the upper surface 11a corresponds to the outer edge 12b of the bonding member 12. In this example, when projected onto the upper surface 11a, the grooves 17 are disposed inside an outer edge 13b of the bonding electrode 13 and are disposed inside an outer edge 14b of the wiring substrate 14.

A shape of the side surface of the bonding member 12 is not limited to a tapered shape. For example, the side surface of the bonding member 12 may be a "center narrow shape" or a "center wide shape". In the "center narrow shape", the width (the length of the X-Y plane) of the bonding member 12 in the central portion is smaller than in the upper and lower portions. In the "center wide shape", the width of the bonding member 12 in the central portion is larger than in the upper and lower portions. The side surface of the bonding member 12 may be a "vertical shape". In the "vertical shape", the width of the bonding member 12 is constant in the thickness direction.

The thickness of the bonding member 12 is, for example, 20 µm or more to 200 µm. In this example, the thickness thereof is 100 µm. The bonding member 12 uses, for example, a solder material. The bonding member 12 may include, for example, at least one selected from a group consisting of Sn-Ag-Cu based solder, Sn-Ag based solder, Sn-Zn based solder, Sn-Ni based solder, and Sn-Cu based solder. A solder material used for the bonding member 12 includes, for example, tin (Sn). The solder material includes a mixed material including, for example, tin (Sn) as a base, and at least one of silver (Ag), copper (Cu), bismuth (Bi), nickel (Ni), indium (In), zinc (Zn), antimony (Sb), and phosphorus (P). The solder material shows the solidus temperature and the liquidus-line temperature in a range of, for example, 200°C to 250°C in the bonding member 12.

The thickness of the bonding member 12 can be controlled using, for example, the protrusions 35 formed in the above-described heat dissipation member 11.

The thickness of the bonding member 12 may be controlled using particles dispersed in the bonding member 12.

For example, particles (for example, metal particles) are dispersed in the bonding member 12. When projected onto the X-Y plane, the density of metal particles included in the bonding member 12 is, for example, 0.2 or more to 10 or less (for example, one particle) per square mm. An average particle diameter of the metal particles is, for example, 50 µm to 200 µm. The metal particle uses, for example, at least one of copper (Cu), silver (Ag), and Ni. In addition, the metal particle may include a plurality of materials. The metal particle may include, for example, a Cu particle and a Ni coat layer provided on the surface of the particle. The Ni coat layer has a function of suppressing diffusion. As such, a particle including two or more metal layers may be used as the metal particle. As the metal particle, an alloy material where two or more kinds of metals are mixed may be used. In addition, as the particle, a resin or ceramic particle of which a surface is coated with a metal material may be used.

The wiring substrate 14 is disposed on the bonding member 12. A shape of the wiring substrate 14 projected onto the X-Y plane is, for example, a rectangular shape. In this example, when projected onto the X-Y plane, the outer edge 14b of the wiring substrate 14 is located inside the outer edge 12b. The grooves 17 are located inside the outer edge 14b. The outer edge 14b is separated from the grooves 17. Each of the lengths of the wiring substrate 14 in the X direction and the Y direction is, for example, 30 mm. The thickness of the wiring substrate 14 is, for example, 100 µm or more to 2 mm or less. In this example, the thickness thereof is 1 mm. The wiring substrate 14 uses, for example, ceramic.

The bonding electrode 13 is provided on the lower surface of the wiring substrate 14. A shape of the bonding electrode 13 projected onto the X-Y plane is, for example, a rectangular shape. When projected onto the X-Y plane, the outer edge 13b of the bonding electrode 13 is located inside the outer edge 12b. In addition, as described later, the bonding electrode 13 may have the same size as that of the outer edge 12b, as needed. The grooves 17 are located inside the outer edge 13b. The outer edge 13b is separated from the grooves 17. Each of the lengths of the bonding electrode 13 in the X direction and the Y direction is, for example, 29 mm. In this example, the length of the first groove portions 17x in the X direction is shorter than the length of the wiring substrate 14 in the X direction, and is shorter than the length of the bonding electrode 13 in the X direction. The length of the first groove portions 17x in the X direction is, for example, 28 mm. In addition, the length of the second groove portions 17y in the Y direction is shorter than the length of the wiring substrate 14 in the Y direction, and is shorter than the length of bonding electrode 13 in the Y direction. The length of the second groove portions 17y in the Y direction is, for example, 28 mm. The thickness of the bonding electrode 13 is, for example, 10 µm or more to 200 µm or less. In this example, the thickness of the bonding electrode 13 is 50 µm.

The bonding electrode 13 uses a material with high thermal conductivity, for example, copper. A plated layer may be provided on the surface of the bonding electrode 13. A laminate structure including, for example, a Ni layer which is 1 µm to 5 µm thick and a gold layer which is 0.01 µm to 0.5 µm thick is applied to this plated layer. Electrolytic plating or non-electrolytic plating is used to form this plated layer. A three-layer structure having a layer including Ni, a layer including Pd, and a layer including Au may be applied to the plated layer. For example, electrolytic plating or non-electrolytic plating is used to form this plated layer. As the plated layer, a single electrolytic plating layer including Ag may be used.

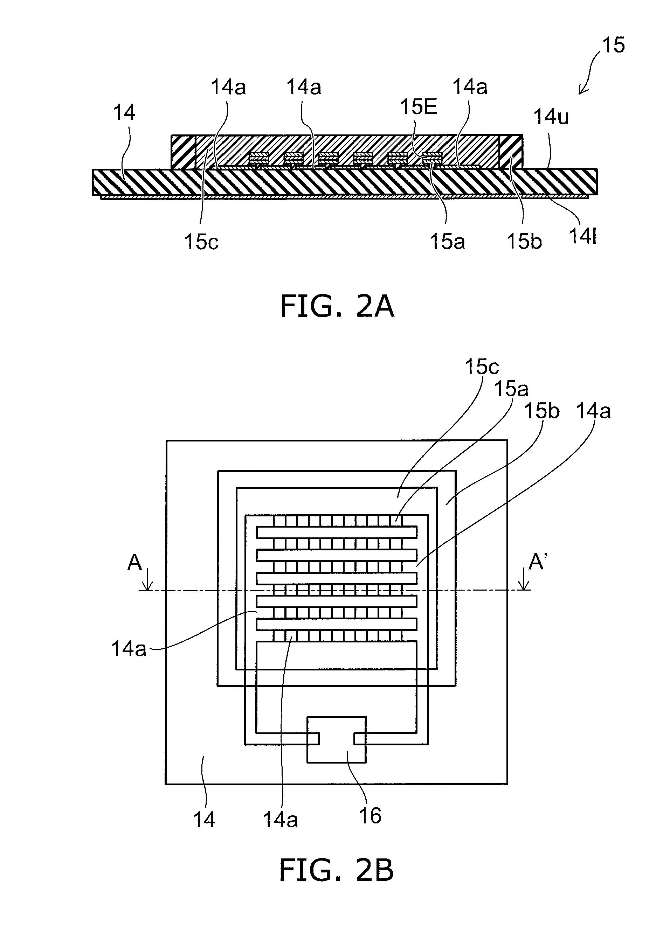

FIGS. 2A and 2B are schematic diagrams illustrating a configuration of the semiconductor device according to the first embodiment.

FIG. 2B is a plan view illustrating a configuration of the light emitting unit 15. FIG. 2A is a cross-sectional view taken along the line A-A' of FIG. 2B.

As shown in FIGS. 2A and 2B, the light emitting unit 15 is provided on the upper surface 14u of the wiring substrate 14. The light emitting unit 15 includes, for example, a plurality of semiconductor light emitting elements 15a emitting light, a frame 15b surrounding the semiconductor light emitting elements 15a, and a sealing resin 15c filling the frame 15b.

The semiconductor light emitting element 15a includes a light emitting layer 15E. In other words, the light emitting unit 15 (for example, a semiconductor unit) includes the light emitting layer 15E. The light emitting layer 15E is formed on a base material including, for example, sapphire (Al₂O₃), silicon (Si), gallium arsenide (GaAs), or the like. After the light emitting layer 15E is formed, the base material may be removed. The light emitting layer 15E may use various materials such as, for example, a nitride semiconductor (nitride compound semiconductor) such as GaN, or a compound semiconductor such as In-Ga-Al-P.

A circuit wiring 14a is provided on the upper surface 14u of the wiring substrate 14. The semiconductor light emitting elements 15a are joined to the circuit wiring 14a. For example, a conductive material is used for the bonding.

The upper surface of the semiconductor light emitting element 15a has, for example, a rectangular shape with each side of 1 mm. The thickness of the semiconductor light emitting element 15a is, for example, 0.2 mm. A plurality of the semiconductor light emitting elements 15a are disposed on the wiring substrate 14. A plurality of the semiconductor light emitting elements 15a are disposed, for example, in the X direction and the Y direction. For example, the six semiconductor light emitting elements 15a in the X direction and the six semiconductor light emitting elements 15a in the Y direction are disposed in a matrix at the interval of 1 mm. The dimension, number, and disposition of the semiconductor light emitting elements 15a are arbitrary.

The frame 15b is provided on the wiring substrate 14. The region surrounded by the frame 15b is, for example, rectangular when viewed from the upper side. The semiconductor light emitting elements 15a are disposed in the region surrounded by the frame 15b. The lengths in the X direction and the length in the Y direction of the region surrounded by the frame 15b are, for example, 16 mm or more to 18 mm or less. In this embodiment, for example, the length in the X direction is 16 mm, and the length in the Y direction is 18 mm. The height of the frame 15b is larger than the height of the semiconductor light emitting element 15a, and is 0.7 mm or more to 1.5 mm or less (for example, 0.8 mm). The dimension and disposition of the frame 15b are arbitrary.

The region (space) surrounded by the frame 15b is filled with the sealing resin 15c. The semiconductor light emitting elements 15a are sealed with the sealing resin 15c. The sealing resin 15c includes, for example, a wavelength conversion portion. The wavelength conversion portion absorbs some of light beams emitted from the semiconductor light emitting elements 15a and emits light beams having a wavelength different from the wavelength of the emitted light beams. The wavelength conversion portion uses, for example, phosphor. It is possible to obtain light of a desired color by converting a wavelength.

The connector 16 is connected to one end of the wiring (the circuit wiring 14a) via a solder material on the wiring substrate 14. Power for enabling the semiconductor light emitting elements 15a to emit light is supplied via the connector 16. In addition, a cable for supplying power may be directly connected to the wiring substrate 14 using a solder without using the connector 16. A shape of the connector 16 is, for example, a rectangular shape. The lengths of the connector 16 in the X direction and the Y direction are, for example, 4 mm to 5 mm. In this example, for example, the length in the X direction is 4 mm, and the length in the Y direction is 5 mm. The height of the connector 16 is, for example, 1 mm. These dimensions are arbitrary.

In the example shown in FIGS. 2A and 2B, a plurality of the semiconductor light emitting elements 15a are used as the light emitting unit 15, but the embodiment is not limited thereto. The number of the semiconductor light emitting elements 15a may be one. The light emitting unit 15 is provided with one or more semiconductor light emitting elements 15a.

As the light emitting unit 15, for example, a semiconductor light emitting device where a semiconductor light emitting element is mounted on a lead frame may be used. As the light emitting unit 15, a semiconductor light emitting device where a semiconductor light emitting element is stored in a package such as a resin may be used. In the embodiment, such a semiconductor light emitting device may be mounted on the wiring substrate 14. The number of semiconductor light emitting devices mounted on the wiring substrate 14 may be one or two or more.

An example of the manufacturing method of the semiconductor device 1 according to the present embodiment will be described.

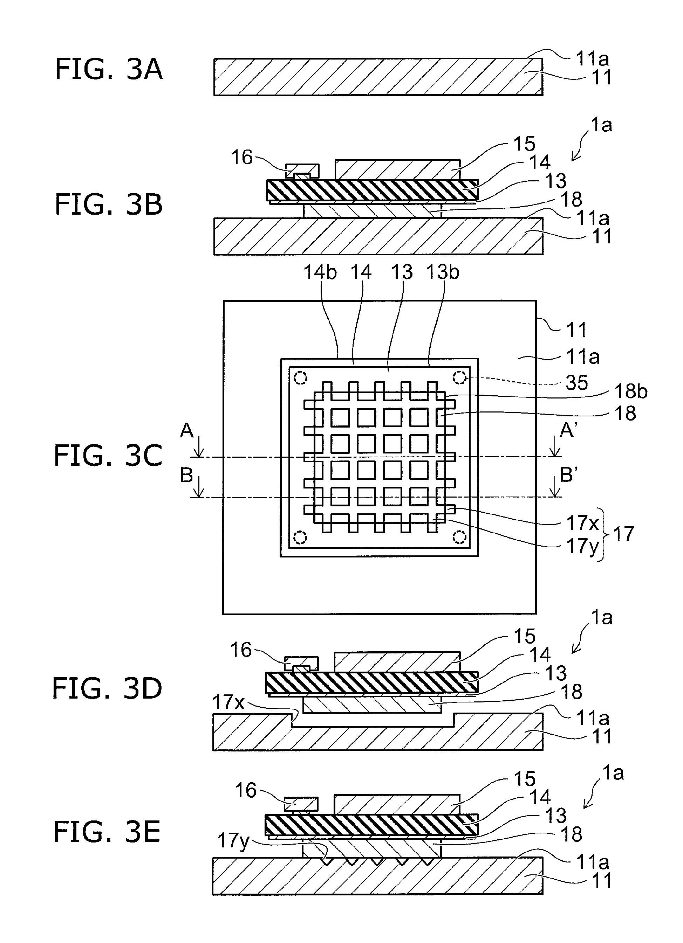

FIGS. 3A to 3E are schematic diagrams illustrating a manufacturing method of the semiconductor device according to the first embodiment.

FIGS. 3A and 3B are side views. FIG. 3C is a transparent plan view illustrating the groove, the bonding electrode, and a bonding member sheet. FIG. 3D is a cross-sectional view taken along the line A-A' of FIG. 3C. FIG. 3E is a cross-sectional view taken along the line B-B' of FIG. 3C.

In FIGS. 3A to 3E, first, an assembly 1a where the respective components included in the semiconductor device 1 are assembled is formed.

First, as shown in FIG. 3A, the heat dissipation member 11 is prepared. The grooves 17 (not shown in this figure) are formed on the upper surface 11a of the heat dissipation member 11. As the grooves 17, for example, a plurality of the first groove portions 17x and a plurality of the second groove portions 17y are formed. A plurality of the protrusions 35 may be formed on the heat dissipation member 11.

Next, as shown in FIGS. 3B, 3D and 3E, a bonding member sheet 18 is disposed on the grooves 17 of the heat dissipation member 11. As the bonding member sheet 18, for example, a solder sheet is used.

The bonding member sheet 18 has a sheet shape. The bonding member sheet 18 includes a bonding material. The bonding material includes, for example, tin (Sn). The bonding material includes a mixed material including tin (Sn) as a base, and at least one of silver (Ag), copper (Cu), bismuth (Bi), nickel (Ni), indium (In), zinc (Zn), antimony (Sb), and phosphorus (P). An amount of the bonding material is larger than the volume of the grooves 17. An amount of the bonding material is, for example, an amount where the grooves 17 are buried and the bonding material uniformly spreads between the heat dissipation member 11 and the bonding electrode 13. The thickness of the bonding member sheet 18 is, for example, 50 µm to 300 µm.

The bonding member sheet 18 may include a plurality of metal particles (for example, nickel (Ni) balls). An average particle diameter of the nickel (Ni) balls is, for example, 50 µm to 200 µm. The density of the nickel balls when projected onto the X-Y plane is, for example, approximately one per square mm.

As shown in FIG. 3C, a shape of the bonding member sheet 18 projected onto the X-Y plane is a rectangular shape. When projected onto the X-Y plane, an outer edge 18b of the bonding member sheet 18 intersects the grooves 17. That is to say, the grooves 17 include a portion located inside the outer edge 18b and a portion located outside the outer edge 18b.

As shown in FIGS. 3B, 3D and 3E, the wiring substrate 14 is prepared. The light emitting unit 15 including the semiconductor light emitting elements 15a is disposed on the wiring substrate 14. The connector 16 is disposed on the wiring substrate 14. The bonding electrode 13 is formed on the lower surface of the wiring substrate 14. The wiring substrate 14 is placed on the bonding member sheet 18.

As shown in FIG. 3C, a shape of the bonding electrode 13 projected onto the X-Y plane is, for example, a rectangular shape. When projected onto the X-Y plane, the outer edge 13b of the bonding electrode 13 is located outside the outer edge 18b of the bonding member sheet 18. In addition, the grooves 17 are located inside the outer edge 13b. When projected onto the X-Y plane, the outer edge 13b and the grooves 17 are separated from each other.

A shape of the wiring substrate 14 projected onto the X-Y plane is, for example, a rectangular shape. When projected onto the X-Y plane, the grooves 17 are located inside the outer edge 14b of the wiring substrate 14. The outer edge 14b and the grooves 17 are separated from each other.

In this way, the heat dissipation member 11, the bonding member sheet 18, the bonding electrode 13, the wiring substrate 14, and the light emitting unit 15 form, for example, the assembly 1a. The assembly 1a becomes the semiconductor device 1. The semiconductor device 1 is of, for example, COB (Chip On Board) type.

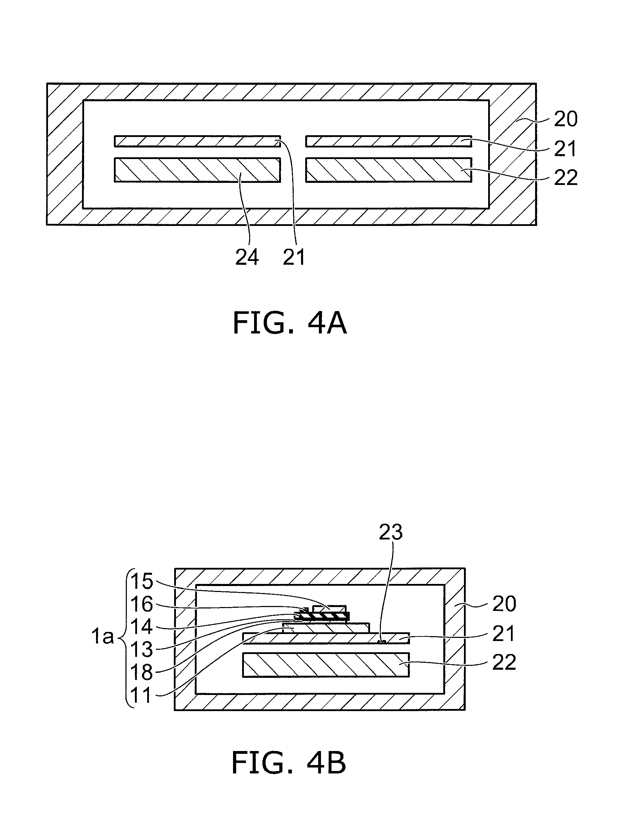

FIGS. 4A and 4B are cross-sectional views illustrating a manufacturing method of the semiconductor device according to the first embodiment.

As shown in FIG. 4A, a plurality of carrier stages 21 are provided inside a chamber 20. A heater 22 is provided below some of the carrier stages 21 in the chamber 20. In addition, a cooling plate 24 is provided below other carrier stages 21.

As shown in FIG. 4B, the assembly 1a of the components is introduced into the chamber 20. The assembly 1a of the components is disposed on the carrier stage 21.

The heater 22 is movable vertically. The heater 22 approaches the carrier stage 21 or the heater 22 comes into contact with the carrier stage 21. Thereby, the assembly 1a of the components mounted on the carrier stage 21 is heated. The carrier stage 21 is provided with a temperature measuring device 23. The temperature measuring device 23 uses, for example, a thermocouple. A temperature of the assembly 1a is controlled by varying a distance between the carrier stage 21 and the heater 22.

When the assembly 1a (or the semiconductor device 1) is disposed on the carrier stage 21 over the cooling plate 24, the assembly 1a is cooled.

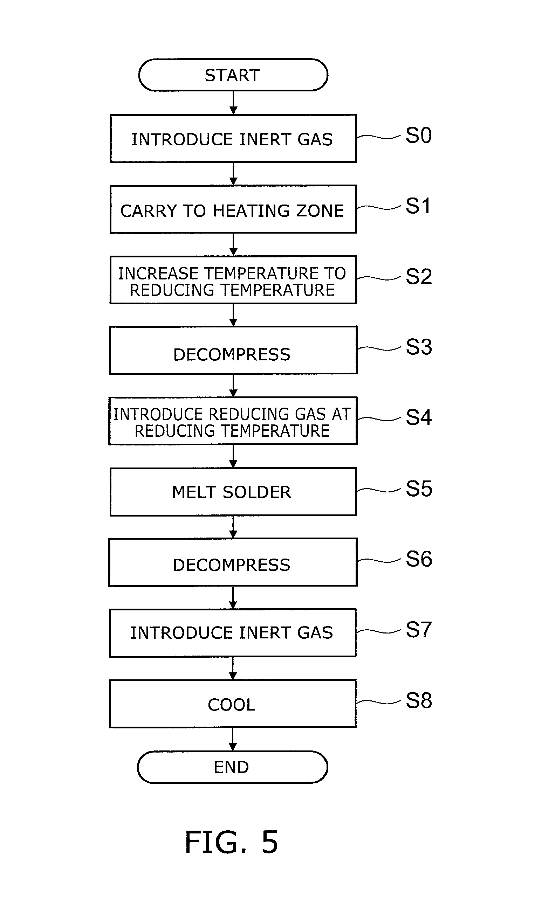

FIG. 5 is a flowchart illustrating a manufacturing method of the semiconductor device according to the first embodiment.

FIG. 5 exemplifies a decompression reflow process using a reducing gas.

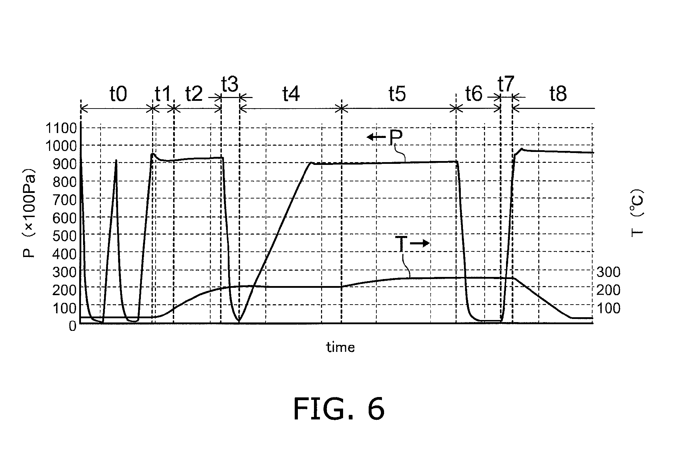

FIG. 6 is a graph illustrating a manufacturing method of the semiconductor device according to the first embodiment.

FIG. 6 is a graph illustrating a pressure profile and a temperature profile in the decompression reflow process. The horizontal axis expresses the time (arbitrary scale), and the vertical axis expresses pressure P or temperature T.

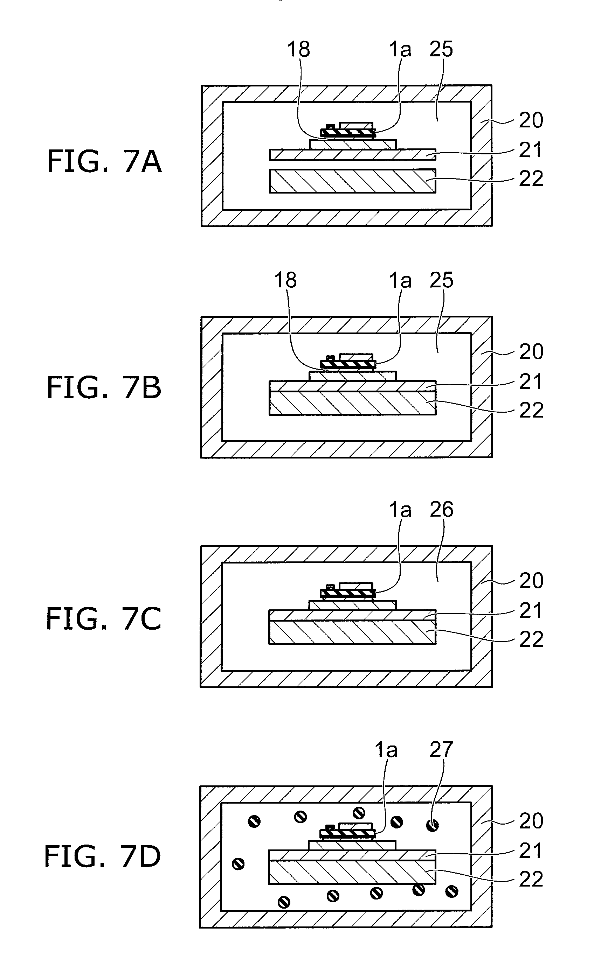

FIGS. 7A to 7D, FIGS. 8A to 8D, and FIGS. 9A to 9C are schematic cross-sectional views illustrating a manufacturing method of the semiconductor device according to the first embodiment.

As shown in step S0 of FIG. 5, the time t0 of FIG. 6, and FIG. 7A, the inside of the chamber 20 is decompressed, and is then filled with an inert gas 25. The pressure at the time of the decompression is, for example, 500 Pascal (Pa). The inert gas 25 uses, for example, nitrogen (N₂). The pressure P of the inside of the chamber 20 is set to the atmospheric pressure or less, for example, 90000 Pascal (Pa), by the filling of the inert gas 25. The decompression and the filling are repeated twice. An oxide film is formed on the surfaces of the bonding member sheet 18, the bonding electrode 13, and the heat dissipation member 11. Through the above-described processes, an increase in the thickness of the oxide film due to heating described later is suppressed.

Next, as shown in step S1 of FIG. 5 and the time t1 of FIG. 6, the carrier stage 21 on which the assembly 1a is mounted is carried to a heating zone located on the upper side of the heater 22.

Next, as shown in step S2 of FIG. 5, the time t2 of FIG. 6, and FIG. 7B, a temperature of the assembly 1a increases to a preliminary heating temperature. The temperature T increases to a predetermined temperature for reduction. The predetermined temperature is, for example, 150°C or more, and is a melting point or less of a bonding material (for example, a solder). The heating is performed by, for example, the upper surface of the heater 22 coming into contact with the lower surface of the carrier stage 21. If the bonding member sheet 18 includes tin (Sn) as a bonding material, the predetermined temperature is 220°C or less. The predetermined temperature is preferably a temperature between 150°C and 190°C. The predetermined temperature is, for example, 190°C.

Next, as shown in step S3 of FIG. 5, the time t3 of FIG. 6, and FIG. 7C, the inside of the chamber 20 is decompressed while maintaining the temperature. This removes the inert gas inside the chamber 20 and causes decompressed atmosphere 26. The pressure at the time of the decompression is, for example, 500 Pascal (Pa).

Next, as shown in step S4 of FIG. 5, the time t4 of FIG. 6, and FIG. 7D, gases including reducing gases 27 are introduced into the chamber 20 until reaching specific pressure, and the state is maintained for a specific time. The reducing gas 27 uses, for example, a formic acid (HCOOH) gas. Gases including the formic acid gas are formed by bubbling nitrogen (N₂) in a tank filled with a liquid formic acid. Thereby, gases including the formic acid gas and the nitrogen are formed. The gases contain the formic acid gas of 5% or less (for example, 1%) in terms of the gas volume ratio. The gases including the formic acid gas are introduced into the chamber 20. In addition, the reducing gas 27 is not limited to the formic acid gas. The reducing gas 27 may use, for example, hydrogen (H₂).

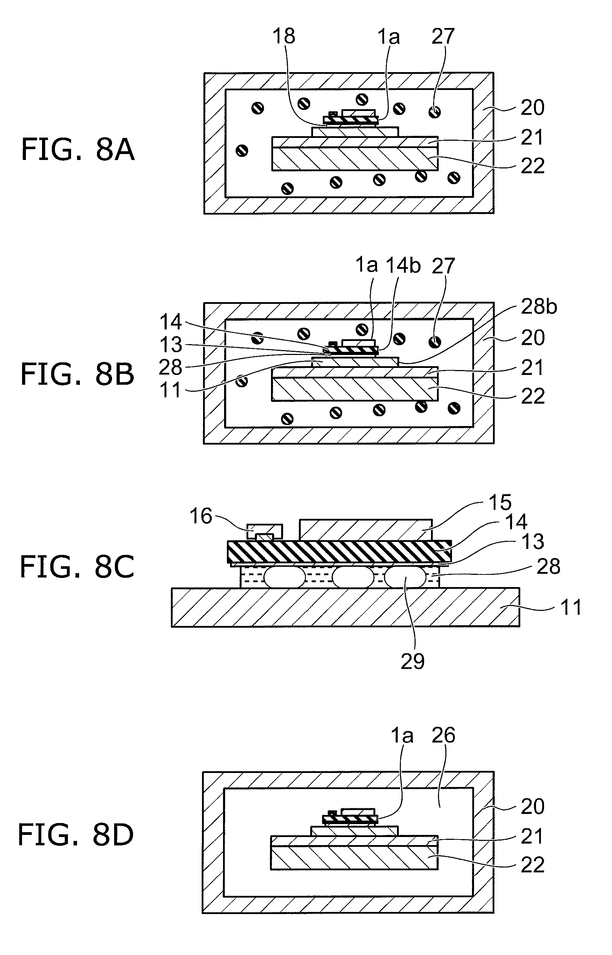

As shown in FIG. 8A, an oxide of the bonding material of the bonding member sheet 18, an oxide on the surface of the bonding electrode 13, and an oxide on the surface of the heat dissipation member 11 undergo reductive reaction by introducing the reducing gas 27. The oxide of the bonding material is, for example, an oxide of tin (Sn). The oxide of the bonding material is an oxide of a mixed material including tin (Sn) as a base, and at least one of silver (Ag), copper (Cu), bismuth (Bi), nickel (Ni), indium (In), zinc (Zn), antimony (Sb), and phosphorus (P).

The reductive reaction between the formic acid (HCOOH) and the oxide (MO) of a bonding material 28 is expressed by, for example, the following Expression 1.

HCOOH+MO → M+H₂O+CO₂ (1)

After the reductive reaction occurs for a predetermined time, as shown in step S5 of FIG. 5, the time t5 of FIG. 6, and FIG. 8B, heating is performed the temperature is maintained for a predetermined time. A heating temperature is equal to or higher than a melting point of the bonding material 28 of the bonding member sheet 18. The heating temperature is equal to or higher than the liquidus-line temperature of the bonding material 28. If the bonding member sheet 18 is a solder material, the heating temperature is higher than the liquidus-line temperature by, for example, about 20°C to 30°C. In consideration of temperature unbalance of processed locations, the heating temperature is set to a temperature capable of reliably melting a solder. In the embodiment, a heating peak temperature is, for example, 250°C. Thereby, the bonding material 28 (for example, a solder) of the bonding member sheet 18 melts.

The melted bonding material 28 wetly spreads between the heat dissipation member 11 and the bonding electrode 13. The melted bonding material 28 buries the grooves 17 and covers regions directly on the grooves 17. For example, when projected onto the X-Y plane, an outer edge 28b of the melted bonding material 28 is located outside the outer edge 14b.

As necessary, the wiring substrate 14 may be pressurized using a jig or the like, and a solder (the melted bonding material 28) may spread over the entire bonding electrode 13. Thereby, the thickness of the bonding material 28 becomes a thickness corresponding to the height of the protrusions 35 formed on the surface of the heat dissipation member 11. Alternatively, the thickness of the bonding material 28 becomes a thickness corresponding to the size of the metal particle mixed in the solder. Accuracy of the thickness of the bonding material 28 is improved.

In this state, the outer edge 28b of the bonding material 28 is separated from the grooves 17. In addition, a taper which spreads on the heat dissipation member 11 side is formed in the side surface of the melted bonding material 28. In some cases, the side surface of the bonding material 28 has a vertical shape depending on characteristics of the bonding material 28, a material and a state of the heat dissipation member 11, gas atmosphere, or a condition such as temperature. In addition, in some cases, the side surface has a center narrow shape or a center wide shape.

As shown in FIG. 8C, bubbles 29 are necessarily generated inside the melted bonding material 28. As causes that the bubbles 29 are generated, there are, for example, the following three causes.

A first cause is a gas existing in a gap of a material forming the assembly 1a. This gas is called "entrained void".

A second cause is a gas which is not reduced and is thus trapped in the metal surface oxide film. In the oxide film portion, a solder does not wet other materials, and thus bubbles around the oxide film cannot be excluded even if decompression is performed.

A third cause is a gas including water vapor (H₂O) and carbon dioxide (CO₂) generated through the reductive reaction in the above-described Expression 1.

Next, as shown in step S6 of FIG. 5, the time t6 of FIG. 6, and FIG. 8D, the inside of the chamber 20 is decompressed while maintaining the temperature. The inside of the chamber 20 becomes the decompressed atmosphere 26. The pressure at the time of the decompression is, for example, 500 Pascal (Pa).

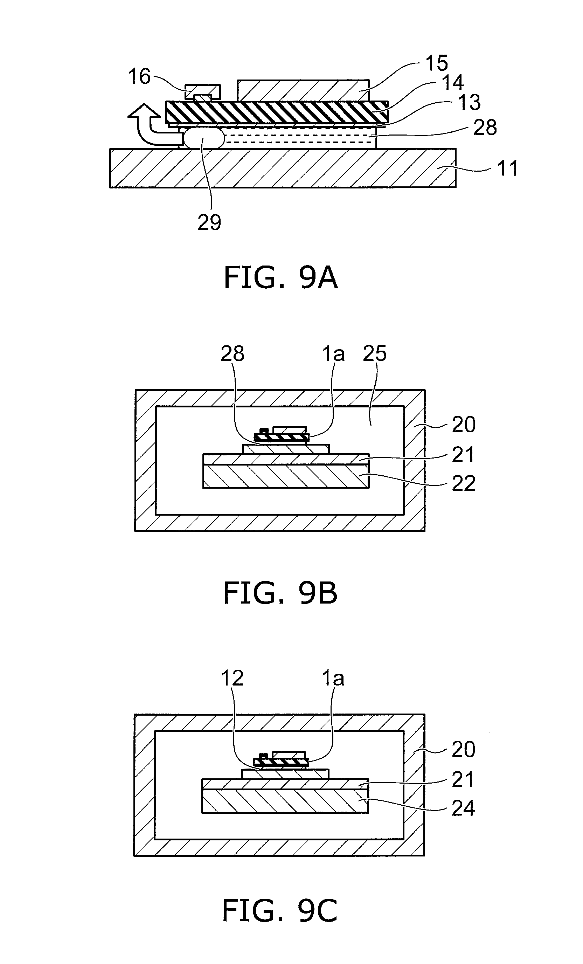

As shown in FIG. 9A, by decompressing the inside of the chamber 20, the bubbles 29 remaining inside the melted bonding material 28 are exhausted to outside of the melted bonding material 28. In this way, it is possible to decrease the volume of the bubbles 29 remaining in the bonding material 28. The number of the bubbles 29 decreases.

Next, as shown in step S7 of FIG. 5, the time t7 of FIG. 6, and FIG. 9B, the inert gas 25 is introduced into the chamber 20 while maintaining the temperature. The pressure of the inside of the chamber 20 at this time is set to the atmospheric pressure or less, for example, 90000 Pascal (Pa).

Next, as shown in step S8 of FIG. 5, the time t8 of FIG. 6, and FIG. 9C, the carrier stage 21 is disposed on the cooling plate 24. This cools the assembly 1a of the components on the carrier stage 21. The melted bonding material 28 is solidified and is used as the bonding member 12. In this way, the semiconductor device 1 shown in FIG. 1 is formed.

In the semiconductor device 1 according to the present embodiment, the grooves 17 are formed on the upper surface 11a of the heat dissipation member 11. Therefore, the reducing gas 27 can reach the surface of the bonding member sheet 18 via the grooves 17. Thereby, it is possible to efficiently perform the reductive reaction of the surface oxide film of the bonding member sheet 18, the surface oxide film of the bonding electrode 13, and the surface oxide film of the heat dissipation member 11. Therefore, when the bonding member 12 melts, it is possible to reliably perform bonding between the bonding member 12 and the bonding electrode 13, and bonding between the bonding member 12 and the heat dissipation member 11 by suppressing hindrance due to the surface oxide films. If a solder material is used as the bonding member 12, it is possible to suppress poor wetting between the bonding electrode 13 and the solder and poor wetting between the heat dissipation member 11 and the solder due to the remaining surface oxide film. Thereby, it is possible to obtain a bonding portion where poor wetting is suppressed.

If the surface oxide film remains, the bubbles 29 are likely to remain in the bonding member 12 after being joined. In the present embodiment, it is possible to obtain a bonding portion where remaining of the bubbles 29 is suppressed.

In the present embodiment, the remaining bubbles 29 are few. For example, a reducing gas is included in the remaining bubbles 29. Reactants generated by, for example, the reducing gas reducing the surface oxide film are included in the bubbles 29. For example, mixed gases (for example, mixed gases of a formic acid gas and a nitrogen gas, or mixed gases of a hydrogen gas and a nitrogen gas) of a reducing gas and an inert gas are included in the bubbles 29.

In the embodiment, an amount of the bubbles 29 decreases by suppressing poor bonding (particularly, poor wetting if using a solder material). Thereby, it is possible to improve a mechanical strength or thermal conductivity of the bonding portion.

In the embodiment, the bonding material 28 melts in the decompressed atmosphere 26. Thereby, it is possible to decrease an amount of the bubbles 29 formed in the melted bonding material 28. In addition, it is possible to efficiently exhaust the bubbles 29 to outside via the grooves 17 formed on the upper surface of the heat dissipation member 11. Thereby, it is possible to suppress remaining of the bubbles 29 in the bonding portion of the semiconductor device 1. Therefore, it is possible to improve a mechanical strength or thermal conductivity of the bonding portion.

As described above, the mechanical reliability of the semiconductor device 1 is improved by improving a mechanical strength or thermal conductivity of the bonding portion, and thereby it is possible to improve heat dissipation performance. In addition, operation reliability is improved.

If a formic acid gas is used as the reducing gas 27, the reductive reaction occurs at lower temperature than in a case of using hydrogen. Therefore, it is possible to reduce, for example, manufacturing running costs. In addition, a material with a low melting point can be used as the bonding member 12 (the bonding material 28), and thus it is possible to expand a range of selecting materials for the bonding material 28. In addition, the reductive reaction can be made to occur at low temperature, and thus it is possible to suppress contamination of the semiconductor device 1.

Since the formic acid is less dangerous than the hydrogen which is explosive, it is possible to reduce costs for equipment. In addition, if the bonding electrode 13 includes copper (Cu), it is possible to remove a corrosion inhibitor on the surface of the copper (Cu) with the formic acid. Thereby, it is possible to improve a bonding strength.

An amount of the bonding material 28 is larger than the volume of the grooves 17. An amount of the bonding material 28 is an amount where the grooves 17 are buried and the bonding material uniformly spreads between the heat dissipation member 11 and the bonding electrode 13. If a solder amount is insufficient, bubbles remain in the protruding portion of the bonding member 12. An amount of the bonding material 28 is set to the above-described amount, and thereby it is possible to suppress remaining of the bubbles.

Since the formic acid gas is used for the reductive reaction, a flux is not used for the reductive reaction. Thereby, it is not necessary to perform cleaning for removal of the flux after the reductive reaction. Therefore, it is possible to reduce production costs and decrease contamination.

### First Reference Example

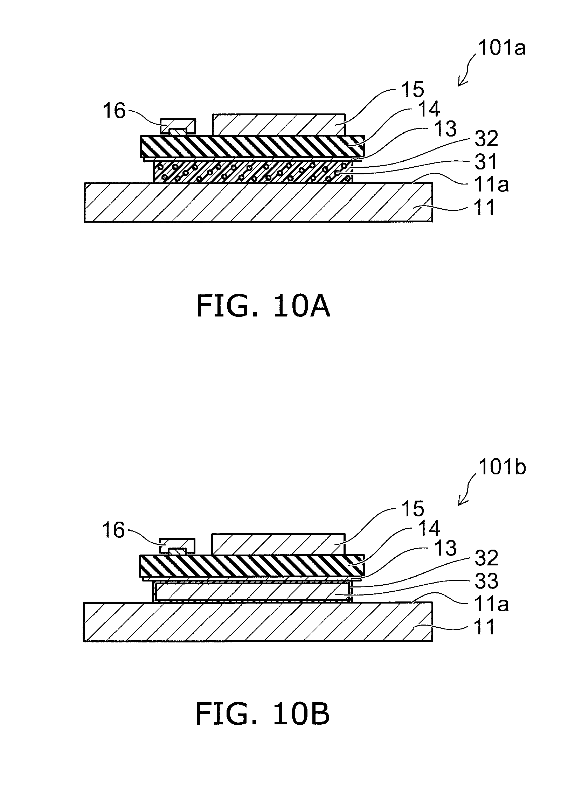

In the first reference example, reductive reaction of a solder is performed using a flux instead of a reducing gas. FIGS. 10A and 10B are schematic cross-sectional views illustrating a manufacturing method of a semiconductor device according to the reference example.

As shown in FIG. 10A, in an assembly 101a of the components according to the reference example, a groove is not formed on the upper surface 11a of the heat dissipation member 11. In addition, a solder paste where granular solders 31 and fluxes 32 are mixed is disposed between the heat dissipation member 11 and the wiring substrate 14 instead of the bonding member sheet.

In the present reference example, as shown in FIG. 10B, in an assembly 101b of the components, a solder sheet 33 of which a surface is coated with the flux 32 may be disposed between the heat dissipation member 11 and the wiring substrate 14.

In the present reference example, in the same manner as the embodiment, as described with respect to FIGS. 4A and 7A, the assembly 101a of the components is introduced into the chamber 20. In addition, the inside of the chamber 20 is filled with the inert gas 25.

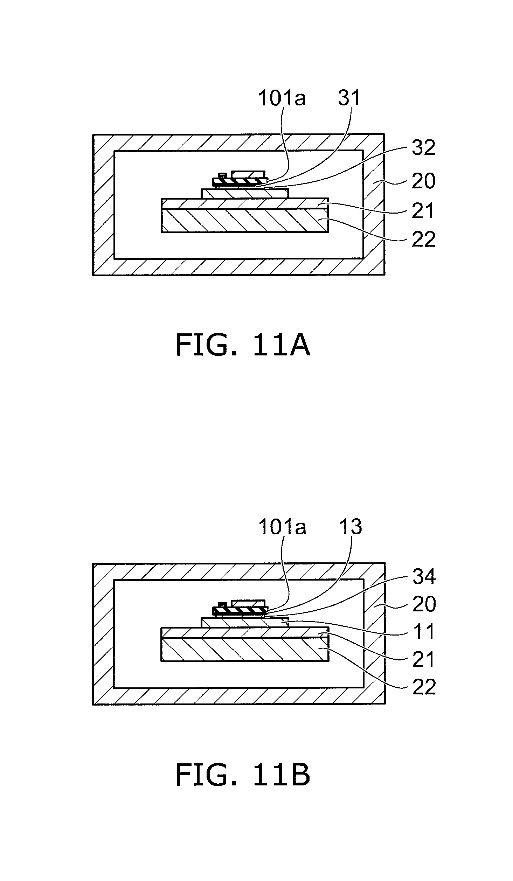

FIGS. 11A and 11B are schematic cross-sectional views illustrating a manufacturing method of the semiconductor device according to the reference example.

As shown in FIG. 11A, heating is performed. Through the heating, the surface oxide film of the bonding member is reduced by a reducing agent in the flux. A heating temperature is, for example, equal to or higher than 150°C, and is equal to or lower than a melting point of the solder to be used. The flux 32 reduces the surface oxide of the bonding material included in the solder 31, the surface oxide film of the bonding electrode, and the surface oxide film of the heat dissipation member.

Next, as shown in FIG. 11B, after reductive reaction is performed for a predetermined time, heating is performed at a melting point or more of the solder 31. This melts the solder 31 in the solder paste. The melted solder 31 spreads between the heat dissipation member 11 and the wiring substrate 14. Thereafter, while maintaining the temperature, the inside of the chamber 20 is decompressed. The pressure is, for example, 500 Pascal (Pa).

Next, in the same manner as the present embodiment, as described with reference to FIGS. 9B and 9C, while maintaining the temperature, the inert gas 25 is introduced into the chamber. Thereby, the pressure of the inside of the chamber 20 is set to 90000 Pascal (Pa). The carrier stage 21 is disposed on the cooling plate 24. A melted solder 34 is solidified. In this way, the semiconductor device according to the first reference example is formed.

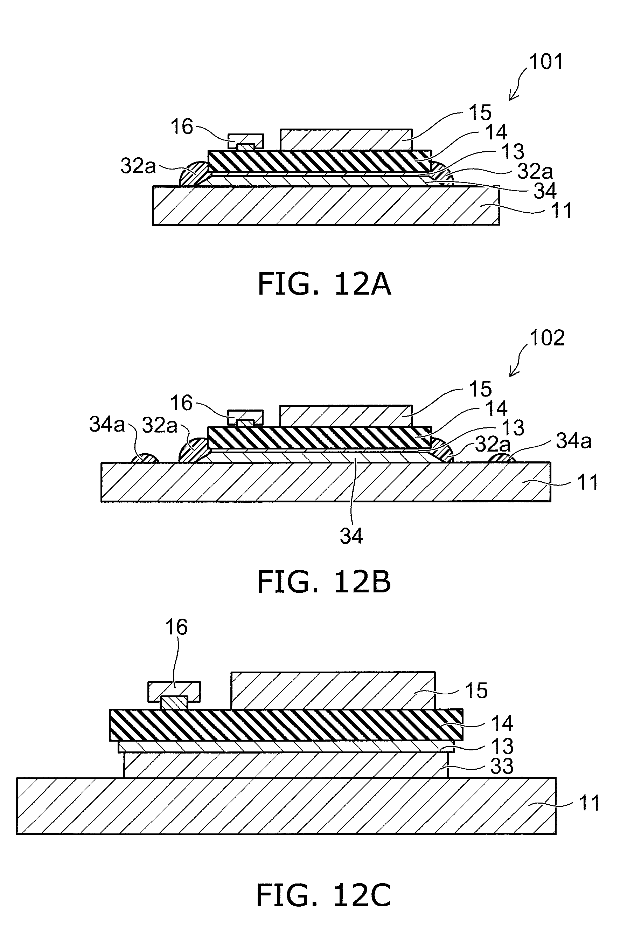

FIGS. 12A and 12B are schematic cross-sectional views illustrating the semiconductor device according to the reference example.

As shown in FIGS. 12A and 12B, the solder 34 is reduced by the flux 32 in semiconductor devices 101 and 102 according to the first reference example. Therefore, a flux remainder 32a adheres to the side surface of the solder 34. Accordingly, a cleaning process is necessary. For this reason, production costs increase.

A surface of the silicon resin used in the light emitting unit 15 has a high adhesive property. If the light emitting unit 15 is sealed with the silicon resin, a flux remainder adheres to a surface of the sealing portion (the sealing resin 15c) again. Thereby, optical characteristics of the semiconductor device deteriorate in some cases. In addition, for example, impurities such as a flux remainder are mixed with the silicon resin. Thereby, there are cases where reliability of the semiconductor device is reduced.

In addition, when the solder 34 melts, the flux 32 explosively boils. Thereby, solder balls 34a including the solder 34 scatter. If the solder balls 34 scatter to a fixing portion such as a screw clamp, fixing cannot be performed in some cases. In addition, electrical short circuits may occur.

In addition, if a flux or a solvent for melting the flux scatters inside the chamber 20, the inside of the chamber 20 is not easy to decompress. This contaminates the light emitting unit 15 (including, for example, the semiconductor light emitting element 15a). Thereby, reliability is reduced.

### Second Reference Example

In the second reference example, the solder sheet 33 is reduced by a reducing gas, and the grooves 17 are not formed on the upper surface 11a of the heat dissipation member 11.

FIG. 12C is a schematic cross-sectional view illustrating a manufacturing method of a semiconductor device according to the reference example.

As shown in FIG. 12C, in the second reference example, the grooves 17 are not formed on the upper surface of the heat dissipation member 11.

In the same manner as the present embodiment, the process exemplified in FIG. 5 is performed.

Since the grooves 17 are not formed on the upper surface of the heat dissipation member 11 in the second reference example, there is no gap in an interface between the bonding electrode 13 and the bonding member 12, and an interface between the bonding member 12 and the heat dissipation member 11. For this reason, a reducing gas does not easily penetrate into the surface of the bonding member sheet 18. Therefore, the reductive reaction does not sufficiently occur, and, for example, the surface oxide film of the bonding member 12 cannot be sufficiently removed. For this reason, bonding between the bonding member 12 and the bonding electrode 13, and bonding between the bonding member 12 and the heat dissipation member 11 are not appropriately performed. In addition, the bubbles 29 are likely to be trapped, and an amount of remaining bubbles 29 inside the bonding member 12 does not easily decrease.

In the second reference example, a path of the bubbles 29 is not secured as compared with a case where the grooves 17 are formed on the upper surface 11a of the heat dissipation member 11. Therefore, the bubbles 29 in the melted bonding material 28 are not easily removed. If a large number of the bubbles 29 remain in the bonding member 12, a mechanical strength or thermal conductivity of the bonding portion is reduced. Thereby, an improvement of a heat dissipation property of the semiconductor device is not easy. In addition, if a large number of the bubbles 29 are included in the bonding portion, a bonding strength between the wiring substrate 14 and the heat dissipation member 11 is reduced.

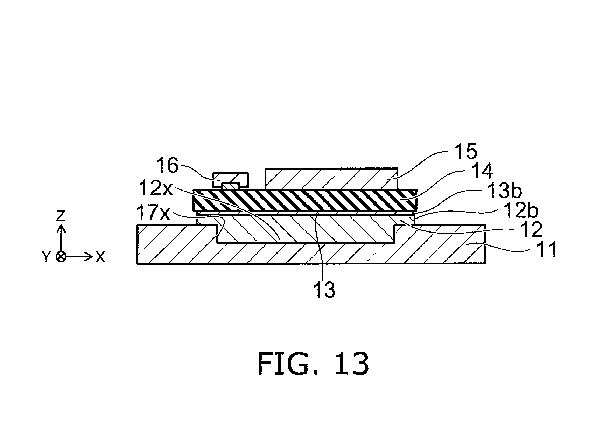

FIG. 13 is a schematic cross-sectional view illustrating a configuration of another semiconductor device according to the first embodiment.

As shown in FIG. 13, in another semiconductor device according to the present embodiment, when projected onto the X-Y plane, the outer edge 12b of the bonding member 12 substantially overlaps the outer edge 13b of the bonding electrode 13. The bonding electrode 13 has the same size as that of the outer edge 12b. For example, the area of the bonding member 12 is substantially the same as the area of the bonding electrode 13. The others are the same as those of the semiconductor device 1. In this example as well, it is possible to improve a heat dissipation property.

### Second Embodiment

In the present embodiment, some of the grooves 17 are also located outside the outer edge 14b of the wiring substrate 14.

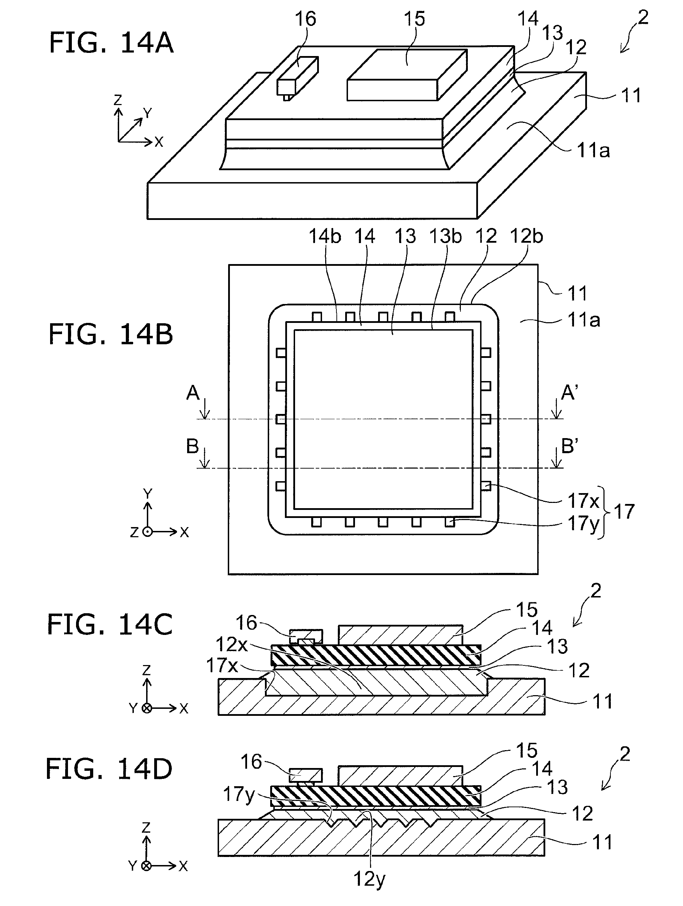

FIGS. 14A to 14D are schematic diagrams illustrating a configuration of a semiconductor device according to the second embodiment.

FIG. 14A is a perspective view. FIG. 14B is a plan view. FIG. 14C is a cross-sectional view taken along the line A-A' of FIG. 14B. FIG. 14D is a cross-sectional view taken along the line B-B' of FIG. 14B.

As shown in FIGS. 14A to 14D, in a semiconductor device 2 according to the present embodiment as well, the heat dissipation member 11, the bonding member 12, and the wiring substrate 14 are provided. The wiring substrate 14 is provided with the bonding electrode 13 and the light emitting unit 15.

As shown in FIG. 14A, the outer edge 13b of the bonding electrode 13 and the outer edge 14b of the wiring substrate 14 intersect the grooves 17 when projected onto the X-Y plane. In other words, the grooves 17 include a portion located inside the outer edge 13b and the outer edge 14b and a portion located outside the outer edge 18b. The other configurations are the same as those of the semiconductor device 1.

A description will be made of an example of the manufacturing method of the semiconductor device 2.

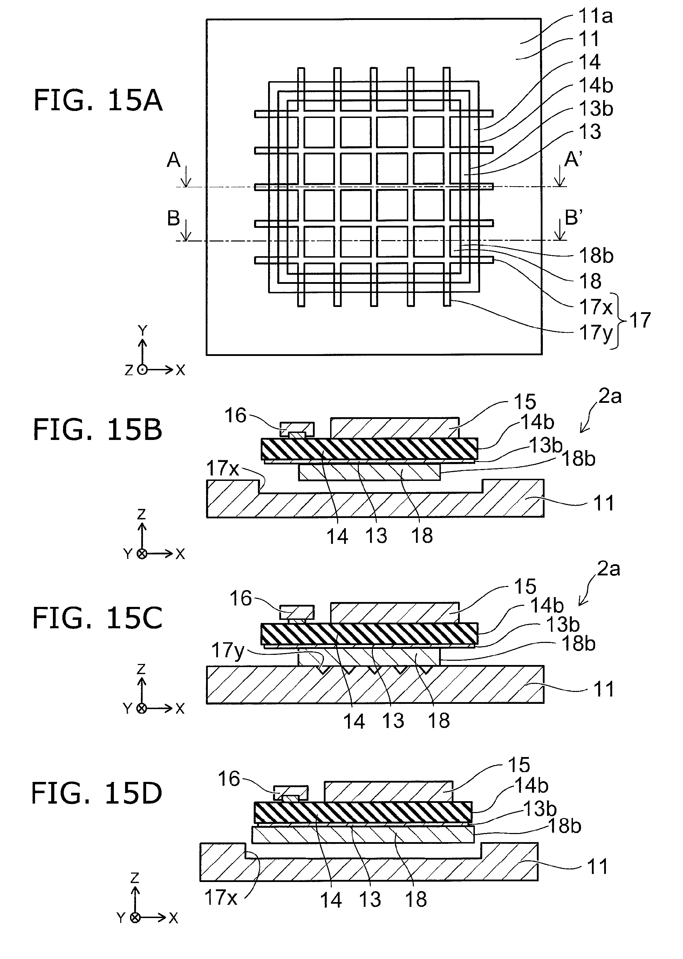

FIGS. 15A to 15D are schematic diagrams illustrating a manufacturing method of the semiconductor device according to the second embodiment.

FIG. 15A is a transparent plan view of the grooves 17, the bonding electrode 13, and the bonding member sheet 18. FIG. 15B is a cross-sectional view taken along the line A-A' of FIG. 15A, and FIG. 15C is a cross-sectional view taken along the line B-B' of FIG. 15A. FIG. 15D is a cross-sectional view illustrating another example corresponding to the line A-A' of FIG. 15A.

As shown in FIG. 15A, the bonding member sheet 18 and the wiring substrate 14 are disposed on the heat dissipation member 11. In this example, the outer edge 13b of the bonding electrode 13 is located outside the outer edge 18b of the bonding member sheet 18. The outer edge 13b is located inside the outer edge 14b. The outer edge 14b intersects the grooves 17.

In this way, an assembly 2a of the components which becomes the semiconductor device 2 is formed.

In the same manner as the first embodiment, the process described with reference to FIG. 5 is performed. Thereby, the semiconductor device 2 exemplified in FIGS. 14A to 14D is manufactured.

In the present embodiment, when projected onto the upper surface 11a, ends of the first groove portions 17x and ends of the second groove portions 17y are located outside the outer edge 13b of the bonding electrode 13 and the outer edge 14b of the wiring substrate 14. Therefore, a reducing gas can be efficiently incorporated from the upper surface 11a of the heat dissipation member 11 which is not covered with the wiring substrate 14. Therefore, the bonding member sheet 18 can be efficiently reduced.

In the present embodiment, it is possible to efficiently exhaust the bubbles 29 from the upper surface 11a of the heat dissipation member 11 which is not covered with the wiring substrate 14. For example, an exhaust time of the bubbles 29 decreases. The grooves 17 are also provided under the outer edge 12b of the bonding member 12. Thereby, it is possible to improve a bonding strength with the heat dissipation member 11. In the present embodiment, it is possible to achieve the characteristics and effects described in the first embodiment in addition thereto.

As shown in FIG. 15D, in the present embodiment, the outer edge 18b of the bonding member sheet 18 may be located outside the outer edge 13b of the bonding electrode 13. In addition, the outer edge 18b of the bonding member sheet 18 may be located outside the outer edge 14b of the wiring substrate 14. In the present embodiment, a position of the outer edge 18b may conform to a position of the outer edge 13b, may be located inside the outer edge 13b, or may be outside the outer edge 13b. A position of the outer edge 18b may conform to a position of the outer edge 14b, may be located inside the outer edge 14b, or may be outside the outer edge 14b.

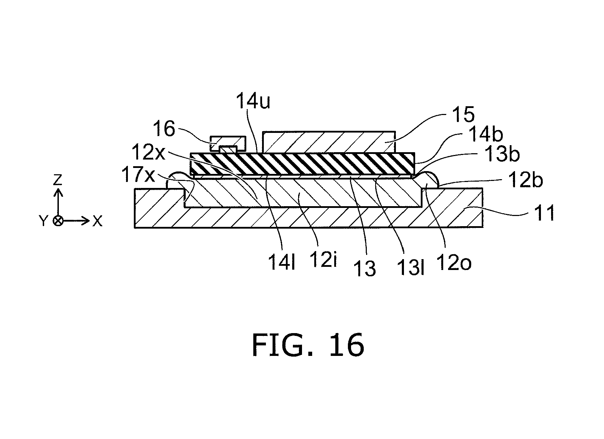

FIG. 16 is a schematic cross-sectional view illustrating a configuration of another semiconductor device according to the second embodiment.

As shown in FIG. 16, in another semiconductor device according to the present embodiment, the outer edge 12b of the bonding member 12 is located outside of the outer edge 13b of the bonding electrode 13. In addition, the outer edge 12b is located outside the outer edge 14b of the wiring substrate 14. In other words, when projected onto the X-Y plane, the bonding member 12 has a portion (inside portion 12i) overlapping the wiring substrate 14 and a portion (outside portion 12o) not overlapping the wiring substrate 14. An upper surface of the outside portion 12o of the bonding member 12 is located further on the upper side than a lower surface 131 of the bonding electrode 13. In this example, the upper surface of the outside portion 12o is located further on the upper side than the lower surface 141 of the wiring substrate 14.

For example, when bonding is performed, the wiring substrate 14 is pressureized using a jig or the like, and thereby a solder (the melted bonding material 28) spreads. There are cases where a distance between the heat dissipation member 11 and the wiring substrate 14 after the bonding becomes smaller than the thickness of the bonding member sheet 18 used in the bonding. After the bonding, the solder protruding from the vicinity of the wiring substrate 14 is higher than a position of the bonding electrode 13 in cross-sectional view. In addition, there are cases where the solder around the wiring substrate 14 is higher than the lower surface 141 of the wiring substrate 14.

In the semiconductor device having such a configuration as well, it is possible to improve a heat dissipation property.

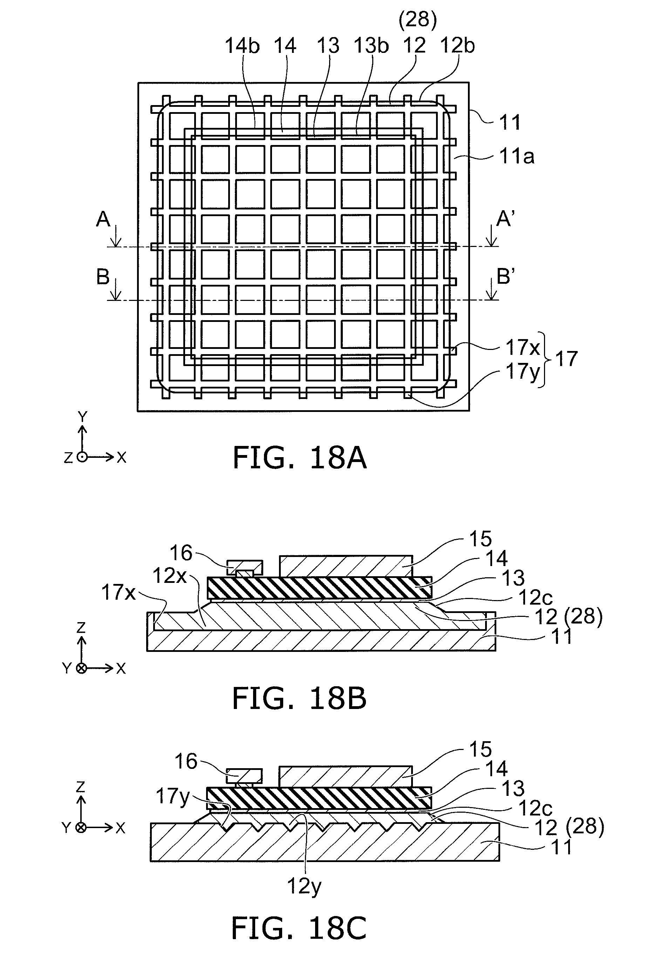

In the present embodiment, as in an example shown in FIGS. 18A to 18C described later, some of intersection portions of a plurality of groove portions (the first groove portions 17x and the second groove portions 17y) may be located outside the outer edge 13b of the bonding electrode 13 when projected onto the X-Y plane. In addition, some of the intersection portions may be located outside the outer edge 14b of the wiring substrate 14.

### Third Embodiment

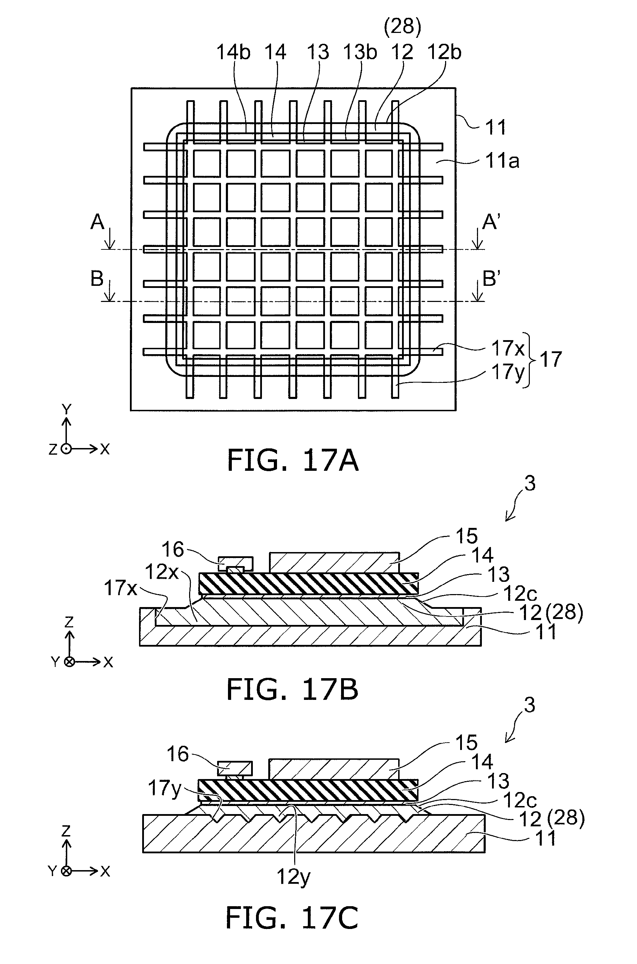

FIGS. 17A to 17C are schematic diagrams illustrating a configuration of a semiconductor device according to a third embodiment.

FIG. 17A is a transparent plan view. FIG. 17B is a cross-sectional view taken along the line A-A' of FIG. 17A. FIG. 17C is a cross-sectional view taken along the line B-B' of FIG. 17A.

As shown in FIGS. 17A to 17C, in a semiconductor device 3 according to the present embodiment as well, the heat dissipation member 11, the bonding member 12, and the wiring substrate 14 are provided. The wiring substrate 14 is provided with the bonding electrode 13 and the light emitting unit 15.

As shown in FIG. 17A, the outer edge 13b of the bonding electrode 13 and the outer edge 14b of the wiring substrate 14 intersect the grooves 17 when projected onto the X-Y plane. The outer edge 12b of the bonding member 12 also intersects the grooves 17. The outer edge 12b of the bonding member 12 is an outer edge of the height surface of the bonding member 12 on the upper surface 11a of the heat dissipation member 11. In the grooves 17, a portion located outside the outer edge 12b is buried by the bonding material 28 which becomes the bonding member 12. The other configurations are the same as those of the semiconductor device 1, and thus description thereof will be omitted.

In manufacturing of the semiconductor device 3, the outer edge 18b of the melted bonding member sheet 18 spreads outside the outer edge 14b of the wiring substrate 14. In addition, the outer edge 18b stays at a position intersecting the grooves 17. Thereby, the outer edge 12b of the bonding member 12 intersects the grooves 17. Further, in the grooves 17, the melted bonding material 28 flows into the outside portion of the outer edge 12b. Thereby, in the grooves 17, the outside portion of the outer edge 12b is buried by the bonding material 28.

As such, in the semiconductor device 3, the grooves 17 are also formed outside the outer edge 12b of the bonding member 12. For this reason, the more reducing gas 27 can be incorporated from a portion of the grooves 17 which is not covered with the bonding member 12. In addition, the more bubbles 29 can be exhausted from the portion which is not covered with the bonding member 12. In the present embodiment, it is also possible to achieve characteristics described in relation to the first embodiment in addition thereto.

FIGS. 18A to 18C are schematic diagrams illustrating a configuration of another semiconductor device according to the third embodiment.

FIG. 18A is a transparent plan view. FIG. 18B is a cross-sectional view taken along the line A-A' of FIG. 18A. FIG. 18C is a cross-sectional view taken along the line B-B' of FIG. 18A.

As shown in FIGS. 18A to 18C, in another semiconductor device according to the present embodiment as well, the heat dissipation member 11, the bonding member 12, and the wiring substrate 14 are provided. The wiring substrate 14 is provided with the bonding electrode 13 and the light emitting unit 15.

As shown in FIG. 18A, some of the grooves 17 are provided outside the outer edge 14b of the wiring substrate 14. Two of a plurality of the first groove portions 17x are provided outside the outer edge 14b in the Y direction. Two of a plurality of the second groove portions 17y are provided outside the outer edge 14b in the X direction.

Some of intersection portions of a plurality of groove portions (the first groove portions 17x and the second groove portions 17y) are located outside the outer edge 13b of the bonding electrode 13 and are located outside the outer edge 14b of the wiring substrate 14 when projected onto the X-Y plane. Some of a plurality of groove portions may be located outside the outward form of a solder fillet.

In this example, since the grooves 17 intersect the solder (the bonding member 12) , the outward form of the solder fillet may be the same as the outward form of the bonding electrode 13. The outward form of the solder fillet need not to be located outside the wiring substrate 14.

In the present embodiment as well, in the same manner as described with reference to FIG. 15D, a position of the outer edge 18b may conform to a position of the outer edge 13b, may be located inside the outer edge 13b, or may be outside the outer edge 13b. A position of the outer edge 18b may conform to a position of the outer edge 14b, may be located inside the outer edge 14b, or may be outside the outer edge 14b.

In the present embodiment as well, it is possible to provide a semiconductor device of which a heat dissipation property is improved.

### Fourth Embodiment

The present embodiment relates to a manufacturing method of the semiconductor device.

The present manufacturing method includes a step of providing the bonding member 12 on the heat dissipation member 11 of which the grooves 17 are formed on the upper surface 11a. The present manufacturing method includes a step of placing the wiring substrate 14 on the bonding member 12. The wiring substrate 14 includes the light emitting unit 15 provided on the upper surface 14u of the wiring substrate 14 and the bonding electrode 13 provided on the lower surface 141 of the wiring substrate 14. The present manufacturing method further includes a step of burying the grooves 17 with the bonding member 12 and bonding the bonding electrode 13 to the heat dissipation member 11 using the bonding member 12.

In other words, for example, the processes described with reference to FIGS. 5, 6, 7A to 7D, 8A to 8D, and 9A to 9C are performed.

For example, the bonding step may further include a step of reducing a surface oxide film of the bonding member 12, a surface oxide film of the bonding electrode 13, and a surface oxide film of the heat dissipation member 11 using gases including a reducing gas. For example, the bonding step may further include a step of melting the bonding member 12. The bonding step may further include a step of decreasing an amount of bubbles remaining inside the melted bonding member.

The bonding step (for example, the melting step) is performed, for example, in a decompressed atmosphere (atmosphere where pressure is lower than the atmospheric pressure). For example, the bonding step includes melting the bonding member 12 and burying the entire grooves 17 with the melted bonding member 12.

The bonding step (for example, the melting step) includes burying the grooves 17 with the melted bonding member 12, and spreading the outer edge 12b of the melted bonding member 12 coming into contact with the upper surface 11a of the heat dissipation member 11 to, for example, a position separated from the grooves 17.

In an example of the above-described manufacturing method, when projected onto the plane (X-Y plane) parallel to the upper surface 11a of the heat dissipation member 11, the outer edge 12b of the bonding member 12 is formed so as to intersect the grooves 17.

In an example of the above-described manufacturing method, when projected onto the X-Y plane, the outer edge 14b of the wiring substrate 14 is formed to be separated from the grooves 17.

In an example of the above-described manufacturing method, when projected onto the X-Y plane, the outer edge 14b of the wiring substrate 14 is formed so as to intersect the grooves 17.

According to the manufacturing method of the semiconductor device according to the present embodiment, it is possible to provide a manufacturing method of a semiconductor device with a high heat dissipation property.

According to the above-described embodiments, it is possible to provide a semiconductor device with a high heat dissipation property and a manufacturing method thereof.

In the present specification, a "state provided on" includes not only a state provided directly on so as to come into contact therewith but also a state of another constituent element being interposed therebetween. A "state provided under" includes not only a state provided directly under but also a state of another constituent element being interposed therebetween.

In the present specification, "vertical" and "parallel" do not refer to vertical and parallel in a strict meaning, but includes, for example, variations and the like in manufacturing steps, and thus may be substantially vertical and substantially parallel.

As above, the embodiments of the present invention have been described with reference to the detailed examples. However, the present invention is not limited to the detailed examples. For example, a detailed configuration of each constituent element such as the heat dissipation member, the bonding member, the wiring substrate, the light emitting unit, the bonding electrode, and the semiconductor light emitting element included in the semiconductor device is included in the scope of the present invention as long as a person skilled in the art appropriately select the configuration from a well-known scope and achieves the same effects by implementing the present invention in the same manner.

In addition, combinations of two or more elements of the detailed examples in a range which is technically possible are also included in the scope of the present invention as long as they include the gist of the present invention.

In addition, all the semiconductor devices and manufacturing methods which a person skilled in the art can implement through appropriate design change on the basis of the semiconductor device and the manufacturing method described as embodiments of the present invention are also included in the scope of the present invention as long as they include the gist of the present invention.

Furthermore, a person skilled in the art can conceive of various modifications and alterations in the spirit of the present invention, and therefore it is understood that the modifications and alterations are also included in the scope of the present invention.

Although some embodiments of the present invention have been described, the embodiments are presented as an example and are not intended to limit the scope of the invention. These novel embodiments can be implemented as other various forms and may carry out various omissions, alterations, and modifications in the scope without departing from the spirit of the invention. These embodiments and modifications thereof are included in the scope or the spirit of the invention and are also included in the invention recited in the claims and the equivalent scope thereof.

## Claims

1. A semiconductor device (1, 2, 3) comprising:
a heat dissipation member (11) having a first upper surface (11a) the first upper surface (11a) being provided with grooves (17) formed on the first upper surface (11a);
a bonding member (12) provided on the heat dissipation member (11) and burying the grooves (17); and
a wiring substrate (14) provided on the bonding member (12), the wiring substrate (12) having a second upper surface (14u) and a lower surface (141) opposite to the second upper surface (14u), the wiring substrate (14) including a semiconductor unit (15) and a bonding electrode (13), the semiconductor unit (15) being provided on the second upper surface (14u) and including a light emitting layer (15E), the bonding electrode (13) being provided on the lower surface (141), the bonding electrode (13) being bonded to the heat dissipation member (11) via the bonding member (12).

2. The device (1, 2, 3) according to claim 1, wherein the grooves (17) of the heat dissipation member (11) are all buried by the bonding member (12).

3. The device (1) according to claim 1 or 2, wherein all the grooves (17) of the heat dissipation member (11) are formed so as to be located inside an outer edge (13b) of the bonding electrode (13) in a state where the bonding electrode (13) is fixed by the bonding member (12).

4. The device (2, 3) according to claim 1 or 2, wherein a part of the grooves (17) of the heat dissipation member (11) are formed so as to be located outside an outer edge (13b) of the bonding electrode (13) in a state where the bonding electrode (13) is fixed by the bonding member (12).

5. The device (1, 2, 3) according to any one of claims 1 to 4, wherein the grooves (17) include a plurality of first groove portions (17x) and a plurality of second groove portions (17y) intersecting the first groove portions (17x).

6. The device (1, 2, 3) according to any one of claims 1 to 5, wherein a side surface of the bonding member (12) is formed with a taper (12c) which spreads on a side of the heat dissipation member (11).

7. The device (1) according to claim 1 or 2, wherein an outer edge (12b) of a surface of the bonding member (12) coming into contact with the first upper surface (11a) is separated from the grooves (17).

8. The device (1) according to claim 1 or 2, wherein the grooves (17) are disposed inside an outer edge (13b) of the bonding electrode (13) and are disposed inside an outer edge (14b) of the wiring substrate (14) when projected onto the first upper surface (11a).

9. The device (2, 3) according to claim 1 or 2, wherein ends of the grooves (17) are disposed outside an outer edge (13b) of the bonding electrode (13) and are disposed outside an outer edge (14b) of the wiring substrate (14) when projected onto the first upper surface (11a).

10. The device (1, 2, 3) according to any one of claims 1 to 9, wherein the bonding member (12) includes bubbles (29), the bubbles (29) include at least one of
a reactant generated by reducing at least one oxide of the bonding member (12), the bonding electrode (13), and the heat dissipation member (11);
a mixture of a reducing gas (27) and an inert gas (25); and
the reducing gas (27).

11. The device (1, 2, 3) according to claim 10, wherein the reducing gas (27) includes at least one of a formic acid gas and a hydrogen gas.

12. A manufacturing method of a semiconductor device (1, 2, 3) comprising:
providing a bonding member (12) on a heat dissipation member (11), the heat dissipation member (11) having a first upper surface (11a), the upper surface (11a) being provided with having grooves formed (17) formed on the first upper surface (11a);
placing a wiring substrate (14) on the bonding member (13), the wiring substrate (14) having a second upper surface (14u) and a lower surface (141) opposite to the second upper surface (14u), the wiring substrate (14) including a semiconductor unit (15) and a bonding electrode (13), the semiconductor unit (15) being provided on the second upper surface (14u) and including a light emitting layer (15E), the bonding electrode (13) being provided on the lower surface (141),
and
bonding the bonding electrode (13) to the heat dissipation member (11) via the bonding member (12) by burying the grooves (17) with the bonding member(12).

13. The manufacturing method of the semiconductor device (1, 2, 3) according to claim 12, wherein the bonding further includes
reducing an oxide film of the bonding member (12) provided on a surface of the bonding member (12), an oxide film of the bonding electrode (13) provided on a surface of the bonding electrode (13), and an oxide film of the heat dissipation member (11) provided on a surface of the heat dissipation member (11), using gases including a reducing gas (27):
melting the bonding member (12); and
decreasing an amount of bubbles (29) remaining inside the melted bonding member (12).

14. The manufacturing method of the semiconductor device (1, 2, 3) according to claim 12 or 13, wherein the bonding is performed in a decompressed atmosphere.

15. The manufacturing method of the semiconductor device (1, 2, 3) according to any one of claims 12 to 14, wherein the bonding includes
melting the bonding member (12); and
burying all the grooves (17) with the melted bonding member (12).
